# FASCICULE DE BREVET EUROPEEN

(11) **EP 2 432 033 B1**
(45) Date de publication et mention de la délivrance du brevet: **27.11.2019**
(21) Numéro de dépôt: 11306079.2
(22) Date de dépôt: 29.08.2011
(51) Int. Cl.: H01L 31/101

(54) **Détecteur bispectral multicouche à photodiodes**
Bispektraler Mehrschichtdetektor mit Fotodioden
Multi-layer bispectral detector with photodiodes

(30) Priorité: 16.09.2010 FR 1057392
(43) Date de publication de la demande: 21.03.2012
(73) Titulaire: COMMISSARIAT À L'ÉNERGIE ATOMIQUE ET AUX ÉNERGIES ALTERNATIVES, 75015 Paris (FR)
(72) Inventeur: Gravrand, Olivier, 38120 FONTANIL-CORNILLON (FR); Baylet, Jacques, 38100 GRENOBLE (FR)
(74) Mandataire: Cabinet Laurent & Charras

(56) Documents cités:
- EP-A2- 0 747 962
- US-A- 6 034 407

## Description

### DOMAINE DE L'INVENTION

L'invention a trait au domaine de la détection bispectrale, et plus particulièrement la détection bispectrale à l'aide d'éléments unitaires de détection constitués d'un empilement de différentes couches d'absorption.

### ETAT DE LA TECHNIQUE

La détection bispectrale, et notamment la détection dans deux gammes infrarouges distinctes, telles que les gammes des infrarouges moyens (2,5 - 5,5 micromètres) et des infrarouges lointains (8 - 12 micromètres), présente diverses applications, notamment dans le domaine de l'observation terrestre, la météorologie, etc...

Dans l'idéal, les images formées par un détecteur bispectral dans chacune des deux gammes de détection sont spatialement cohérentes, c'est-à-dire correspondent à la même scène observée, temporellement cohérentes, c'est-à-dire correspondent aux mêmes instants de détection, et de résolution élevée, c'est-à-dire comportant un nombre élevé d'éléments unitaires de détection, ou « pixels », par unité de surface.

Pour satisfaire ces trois contraintes, il a été initialement proposé des détecteurs comprenant deux matrices de détection, chacune dédiée à une gamme de longueurs d'onde, aménagées sur deux voies optiques distinctes, et dont la lecture est synchronisée. De tels détecteurs nécessitent cependant de procéder à un réglage fin des voies optiques pour que leurs centres optiques pointent vers le même point de l'espace et ainsi obtenir la cohérence spatiale recherchée. De tels détecteurs sont encombrants. De plus, non seulement le réglage des voies optiques est délicat, mais en outre les voies optiques se dérèglent au cours de l'utilisation du détecteur, nécessitant des retours fréquents chez le fabriquant.

Afin d'obtenir une cohérence spatiale de manière plus simple, il a été conçu une unique matrice de détection dont les pixels sont capables de détecter deux gammes de longueurs d'onde distinctes, c'est-à-dire des pixels comprenant dans un même espace deux volumes semi-conducteurs d'absorption, chacun dédié à une gamme de longueurs d'onde spécifique et associé à une jonction PN pour la collecte des charges.

Bien entendu, les pixels se doivent d'être distincts les uns des autres du point de vue de la détection, et donc les phénomènes dits de « *cross-talk* » évités au maximum.

Pour satisfaire au mieux l'ensemble de ces contraintes, deux types de détecteur bispectral ont été mis au point. Selon le premier type de détecteur, les pixels présentent une architecture dite « en parallèle ». Selon le second type de détecteur, les pixels présentent une architecture dite en « tête-bêche ».

Le terme « parallèle » indique que pour un pixel bispectral comprenant deux photodiodes, les deux photodiodes sont adjacentes dans le plan principal de l'empilement, et que chacune des photodiodes est associée à une connectique individuelle qui permet de l'adresser séparément de l'autre photodiode. Cette géométrie de pixel permet ainsi d'adresser simultanément ces deux photodiodes, d'où l'expression «parallèle». D'un autre côté, cette géométrie est moins compacte.

Le terme « tête-bêche » indique que pour un pixel bispectral comprenant deux photodiodes, les deux photodiodes sont formées à l'aplomb l'une de l'autre et qu'une seule connectique est prévue pour adresser ces deux photodiodes. Cette géométrie de pixel, conçue pour des raisons de compacité, impose cependant nécessairement que les deux photodiodes soient agencées en « tête-bêche », c'est-à-dire que la cathode d'une photodiode fait face à l'anode de l'autre photodiode. Cette géométrie est plus compacte mais les photodiodes ne peuvent être individuellement adressées puisqu'en soumettant l'empilement à une différence de potentiels donnée, une photodiode est polarisée en direct et l'autre photodiode est polarisée en inverse. Les photodiodes sont ainsi adressées séquentiellement en faisant varier le signe de la différence de potentiels auquel est soumis l'empilement.

Par ailleurs, classiquement, il existe deux façons de fabriquer une pluralité de photodiodes, à savoir une fabrication de type « planar », et une fabrication de type « mesa », donnant lieu respectivement à une géométrie de photodiode dite de type « planar » ou de type « mesa ».

Le terme de « planar » indique que les photodiodes sont fabriquées en réalisant des zones dopées dans une couche semi-conductrice et que la géométrie d'une zone dopée formée dans la couche semi-conductrice est délimitée par un motif formé dans une résine photosensible déposée sur la couche semi-conductrice, et la création à travers ce motif de résine de la zone dopée, par exemple par implantation ionique, diffusion, ou usinage ionique.

Le terme « mésa » indique quant à lui qu'une couche dopée est réalisée sur la totalité d'une couche semi-conductrice, et que les photodiodes sont séparées par une gravure qui les traverse, créant ainsi des "ilots" (ou « mesa ») qui délimitent les zones dopées des photodiodes.

On distinguera ainsi, la géométrie des pixels bispectraux, « parallèle » ou « tête-bêche », de la manière dont sont créées les photodiodes les constituant, à savoir « planar » ou « mesa ».

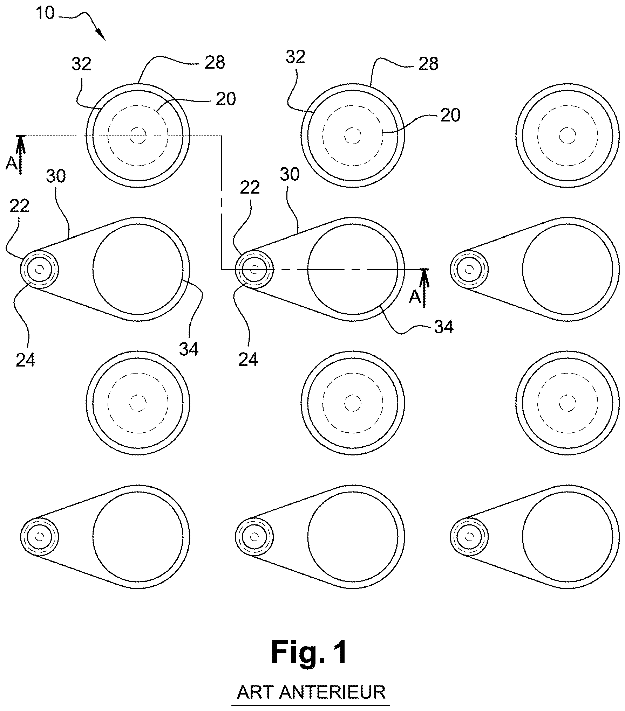

Afin de comprendre les problèmes survenant dans les détecteurs bispectraux existants, il va à présent être décrit, en relation avec les figures 1 à 4, un détecteur matriciel bispectral « en parallèle » **10**, par exemple décrit dans le document « Status ofHgCdTe bicolor and dual-band infrared array at LETI » de Destefanis, JEM 36(8), p.1031, 2007.

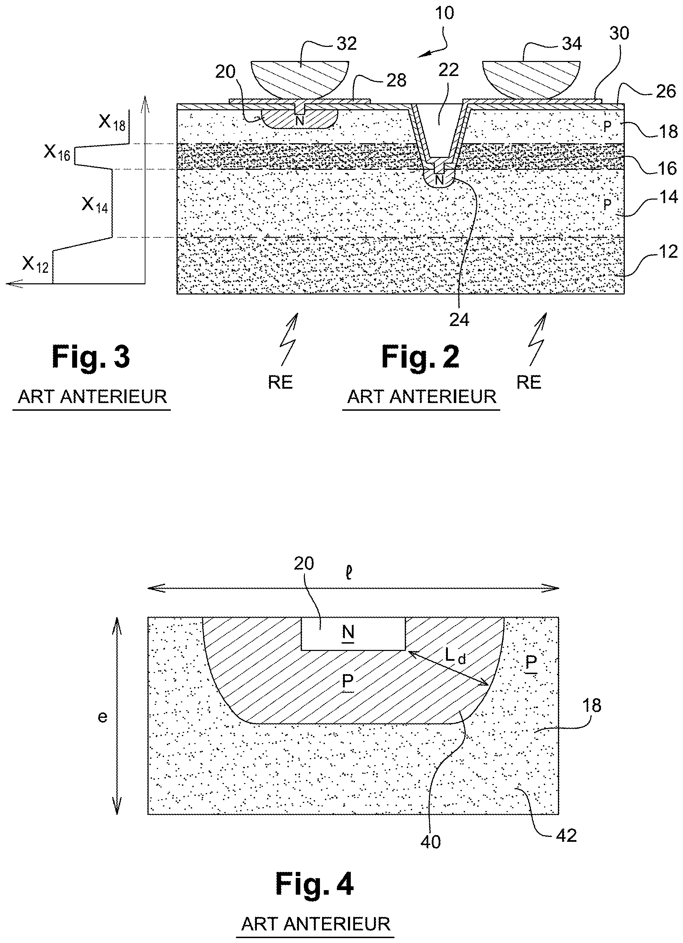

La figure 1 est une vue de dessus de ce détecteur, représenté ici sous la forme d'un détecteur bidimensionnel de trois pixels par deux pixels, la figure 2 est une vue en coupe selon l'axe A-A représenté à la figure 1, la figure 3 est un profil de composition x en cadmium des différents alliages de cadmium, de mercure et de tellure (CdₓHg₁₋ₓTe) formant l'empilement du détecteur **10**, et la figure 4 est une vue en coupe illustrant la zone de charge d'espace dans une jonction PN d'un pixel.

Le détecteur **10** comprend un empilement formé :
▪ d'un substrat **12**, constitué d'un alliage de cadmium, de zinc et de tellure, ou alliage « CZT » ;
▪ d'une couche **14** inférieure d'absorption semi-conductrice de type P, formée sur le substrat **12.** La couche **14** est constituée d'un alliage CdₓHg₁₋ₓTe, dopé P par lacunes de mercure et de faible gap. La composition *x₁₄* en cadmium de la couche **14** est choisie pour que celle-ci soit absorbante dans une première gamme de longueurs d'onde autour d'une longueur d'onde *λ*₁₄ ;
▪ d'une couche **16** intermédiaire formant barrière, réalisée sur la couche inférieure **14.** La couche **16** est constitué d'un matériau de grand gap, par exemple un alliage CdₓHg₁₋ₓTe dont la composition *x₁₆* est importante au regard de la composition en cadmium *x₁₄*, *x₁₈* des couches **14** et **18** ; et
▪ d'une couche **18** supérieure d'absorption semi-conductrice de type P, formée sur la couche **16** formant barrière. La couche **18** est constituée d'un alliage CdₓHg₁₋ₓTe, dopée P par lacunes de mercure et de faible gap. La composition *x₁₈* en cadmium de la couche **18** est choisie pour que celle-ci soit absorbante dans une deuxième gamme de longueurs d'onde autour d'une longueur d'onde *λ*₁₈.

Des zones semi-conductrices de type N **20** sont par ailleurs réalisées dans la couche supérieure **18**, par exemple par implantation ionique de Bore. Cette étape d'implantation ionique a pour effet une conversion du dopage intrinsèque de type P en type N, et forme ainsi une matrice de jonctions PN supérieures, et donc des photodiodes. Cette réalisation des zones N **20** pourraient aussi être faite par implantation ionique de dopants extrinsèques, ou par diffusion de dopants extrinsèques, ou par usinage ionique et conversion de type de dopage de type P en type N.

Des évidements **22** sont en outre gravés au travers de la couche supérieure **18** et d'une partie ou de la totalité de la couche intermédiaire **16.** Des contacts sont aussi gravés jusqu'à la couche inférieure **14** afin d'avoir accès à celle-ci. Des zones semi-conductrices de type N **24** sont réalisées dans la couche inférieure **14** en appliquant le même procédé que celui utilisé pour les couches **20**, à toute ou partie de la couche inférieure **14** affleurant sur le fond des évidements **22**. Une matrice de jonctions PN inférieures, et donc de photodiodes, est ainsi formée dans la couche inférieure **14**.

Une couche de passivation **26** (non représentée sur la figure 1 pour des raisons de clarté des dessins) est en outre déposée sur la face libre de la couche supérieure **28** et dans les évidements **22**.

Enfin, une reprise de contact métallique **28** est formée sur la couche supérieure **18** au dessus de chaque zone **20** et pénètre la zone **20** pour la collecte des charges contenues dans celle-ci. De même, une reprise de contact métallique **30** est déposée dans chaque évidement **22** et pénètre dans la zone **24** correspondante pour la collecte des charges contenues dans cette zone. La reprise de contact **30** se prolonge sur la face supérieure de la couche **18** pour faciliter la connexion de la reprise **30** à une connectique externe (non représentée). Enfin, une bille d'indium **32**, **34** est utilisée sur la partie de chaque reprise de contact **28**, **30** formée sur la couche supérieure **18** pour l'hybridation de l'empilement sur un circuit de lecture (non représenté) par la technique dite de « *flip chip* ».

Le détecteur **10** venant d'être décrit est un détecteur à illumination arrière (« *backside illuminated sensor* »). La face libre du substrat **12** reçoit un rayonnement électromagnétique *RE* qui pénètre l'empilement. La portion du rayonnement *RE* comprise dans la première gamme de longueurs d'onde, est absorbée par la couche inférieure **14**, et la portion du rayonnement *RE* comprise dans la deuxième gamme de longueur d'onde, est absorbée par la couche supérieure **18**.

Comme cela est connu en soi, l'absorption de photons dans les couches inférieure **14** et supérieure **18** libère des porteurs de charge qui diffusent jusqu'aux zones semi-conductrices **20**, **24**, et qui sont collectés par les reprises de contact **28**, **30**. Une polarisation est ou non appliquée entre un contact commun périphérique (non représenté sur la figure 2) et les reprises de contact **28**, **30** d'une manière connue en soi.

Le rôle de la couche intermédiaire **16** est d'empêcher que des porteurs de charge, créés dans l'une des couches **14**, **18**, ne diffusent dans l'autre couche **14**, **18**, provoquant ainsi un phénomène de diaphonie, ou « *cross-talk* », nuisible à la qualité de la détection. Cette fonction est plus communément désignée sous l'expression de fonction « barrière ».

La qualité de la fonction barrière de la couche intermédiaire **16** dépend principalement de la différence existant entre la valeur de la bande interdite ou « *gap* », de la couche intermédiaire **16**, et, d'une part, celle de la couche inférieure **14**, et, d'autre part, celle de la couche supérieure **18**. La couche intermédiaire **16** forme ainsi une barrière de potentiel séparant les bandes de valence et de conduction des couches inférieure **14** et supérieure **16**, limitant donc le passage des porteurs de charge d'une couche à l'autre.

Dans un alliage semi-conducteur du type CdₓHg₁₋ₓTe, la valeur du gap est déterminée principalement par la composition (*1-x)* en mercure, ou de manière équivalente par la composition en cadmium *x*. La figure 3 illustre un profil typique des compositions x en cadmium des différentes couches de l'empilement avec une composition *x₁₆* de la couche intermédiaire **16** supérieure, préférentiellement d'au moins 50%, à chacune des compositions *x₁₄*, *x₁₈* des couches inférieure **14** et supérieure **18**.

Les évidements **22** sont nécessaires pour accéder à la couche inférieure **14**, et ainsi permettre la réalisation des zones semi-conductrices **24**, mais également pour pouvoir réaliser les reprises de contact **30** pour la collecte des charges des zones **24**.

Le détecteur **10** venant d'être décrit présente l'avantage de présenter une géométrie simple, et donc d'être aisément fabriqué, de garantir une bonne cohérence spatiale, mais non parfaite puisque les zones semi-conductrices **20** et **24** sont décalées d'un demi-pas, et de garantir une cohérence temporelle exacte du fait d'une polarisation indépendante des photodiodes.

Outre une cohérence spatiale non exacte, le détecteur **10** présente également le désavantage d'avoir un taux de remplissage non optimal. On entend ici par taux de remplissage le rapport entre la surface optique d'un pixel, c'est-à-dire la zone où le rayonnement absorbé est effectivement collecté par une jonction PN, et la surface géométrique du pixel, définie par exemple par le pas du pixel au carré dans le cas d'un pixel de forme carrée.

Ce phénomène est expliqué en relation avec la figure 4, qui illustre schématiquement en coupe une vue plus en détail une des zones semi-conductrice **20** ou **24**, par exemple la zone **20**, et la couche supérieure **18** ou inférieure **14** correspondante, par exemple à la couche **18**.

Comme cela est connu en soi, la photodiode illustrée à la figure 4 fonctionne en collectant, via la zone **20**, le courant crée par les porteurs de charges libres générés par l'absorption de photons dans la couche **18**. Or, les porteurs de charges transitent dans le matériau constitutif de la couche **18** uniquement sur une distance maximum *L_{d}*, communément appelée longueur de diffusion, avant de se recombiner. De fait, si un porteur de charge est crée dans la couche **18** à une distance de la zone **20** inférieure à la distance *L_{d}*, le porteur de charge est collecté par la zone **20**, sinon le porteur de charge se recombine avant d'avoir atteint la zone **20** et n'est donc pas collecté. Ainsi donc, seul un volume de la couche **18** autour de la zone **20** est exploité pour la détection, ce volume étant communément appelé « zone de collection». Le reste de la couche **18**, ici référencé **42**, est ainsi non exploité.

Il est possible de maximiser la zone de collection **40**, et donc obtenir un meilleur taux de remplissage pour la photodiode considérée, en réalisant un recuit du détecteur à une température appropriée, comme cela est par exemple décrit dans le document « Electrical doping of HgCdTe by ion implantation and heat treatment » de G.L. Destefanis, J. Crystal Growth, 86, 1988, 700-722.

Toutefois, la température de recuit optimale dépend de la composition de la couche dans laquelle les porteurs transitent. Or, les couches **14** et **18** présentent des compositions différentes afin de détecter des gammes de longueurs d'onde différentes. Il n'est ainsi pas possible d'optimiser les zones de collection pour chacune des photodiodes.

Ainsi donc, la structure même des détecteurs, dont les pixels ont une géométrie "en parallèle", dans l'exemple illustré avec deux diodes de type "planar", induit nécessairement un taux de remplissage non satisfaisant et une cohérence spatiale non exacte.

Comme mentionné précédemment, le second type d'architecture de l'état de la technique est du type "tête-bêche".

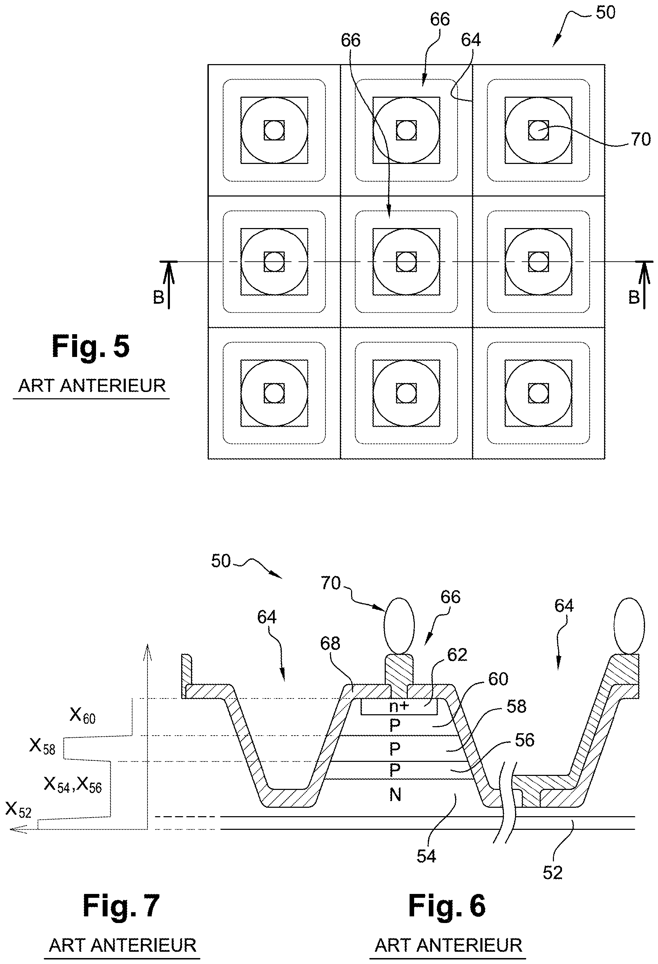

Afin de comprendre les problèmes survenant dans les détecteurs de type "tête-bêche", il va à présent être décrit, en relation avec les figures 5 à 7, un détecteur matriciel bispectral de type "tête-bêche" **50**, par exemple décrit dans le document « Recent advances in the development of infrared multispectral 1282 FPA's » de J. Baylet et al, Proceedings of the society of photo-optical instrumentation engineers, vol. 4721, pp 134-143, 2002.

La figure 5 est une vue de dessus de ce détecteur, représenté ici sous la forme d'un détecteur bidimensionnel de trois pixels par trois pixels, la figure 6 est une vue en coupe selon l'axe B-B représenté à la figure 5, et la figure 7 est un profil de composition x en cadmium des différents alliages de cadmium, de mercure et de tellure (CdₓHg₁₋ₓTe) formant l'empilement du détecteur **50**.

Le détecteur **50** comprend un substrat **52**, constitué d'un alliage CZT, sur lequel sont formées, dans l'ordre :
▪ une première couche semi-conductrice **54**, constituée d'un alliage CdₓHg₁₋ₓTe, dopé N, de composition en cadmium *x₅₄* ;
▪ une deuxième couche semi-conductrice d'absorption **56**, constituée d'un alliage CdₓHg₁₋ₓTe dopé P, de composition en cadmium *x₅₆* choisie pour une absorption dans une première gamme de longueur d'onde, la composition en cadmium de la couche **56** étant supérieure ou égale à la composition en cadmium de la couche **54** ;
▪ une couche intermédiaire **58**, formant barrière et constituée d'un alliage CdₓHg₁₋ₓTe de grand gap, dont la composition *x₅₈* est importante au regard de la composition en cadmium *x₅₆*, *x₆₀* des couches **56** et **60** ; et
▪ une troisième couche semi-conductrice d'absorption **60**, constituée d'un alliage CdₓHg₁₋ₓTe, dopé P, et de composition en cadmium *x₆₀* choisie pour une absorption dans une deuxième gamme de longueurs d'onde.

Des zones semi-conductrices de type N **62** sont réalisées dans la troisième couche **60** et des tranchées **64** sont formées dans l'empilement autour des zones **62** jusqu'à la couche **54** afin de former des pixels sous forme d'ilots **66**. Chaque pixel comprend ainsi une première photodiode constituée des couches P et N **54** et **56**, et d'une seconde photodiode constituée de la couche P **60** et de la zone N **62**.

Une couche de passivation **68** recouvre l'ensemble et un unique élément de connexion métallique **70** est formé sur chaque ilot **66** au contact de la zone **62** de celui-ci pour collecter les charges produites à la fois par la première photodiode **54**, **56** et par la seconde photodiode **60**, **62**.

Enfin, un contact commun périphérique **67** est réalisé au contact de la couche **54** pour appliquer un potentiel commun à tous les ilots **66** lors de la collecte des charges.

Cette géométrie de type "tête-bêche" présente l'avantage d'être très compacte, et ainsi de permettre d'obtenir une résolution importante du détecteur **50**, d'avoir un taux de remplissage très élevé, puisque les jonctions PN sont réalisées par deux couches P et N **54** et **56** déposées l'une sur l'autre. Par ailleurs, une cohérence spatiale exacte est obtenue du fait de la superposition des couches d'absorption **56** et **60**.

Toutefois, la géométrie de type "tête-bêche" présente également des problèmes spécifiques.

En effet, l'empilement selon le motif NP-PN d'un ilot **66** forme deux photodiodes en tête-bêche. Plus particulièrement, lorsque la photodiode formée des couches **54** et **56** est polarisée en direct, la photodiode formée de la couche **60** et de la zone **62** est polarisée en inverse, et vice versa.

Il n'est donc pas possible de collecter simultanément les charges produites par chacune des photodiodes. La collecte est ainsi réalisée séquentiellement en inversant le signe de la différence de potentiels entre le contact **70** et le contact **67**, une photodiode après l'autre, de sorte qu'il n'y a pas de cohérence temporelle entre les détections dans les deux gammes de longueurs d'onde.

Par ailleurs, les pixels sont individualisés au moyen de tranchées **64**, réalisées par exemple par gravure autour de chaque pixel, et se trouvent ainsi sous la forme d'un ilot **66**.

Or, ce type de géométrie est difficile à fabriquer en raison du facteur de forme important qu'elle présente, c'est-à-dire en raison du rapport important entre la profondeur des tranchées **64** et leur largeur.

En effet, tout d'abord, la profondeur des tranchées est importante car il est nécessaire de former celles-ci au moins jusqu'à la couche N **54**. Il est donc nécessaire de graver au moins les couches **56** et **60** qui présentent les épaisseurs les plus importantes en raison de leur fonction d'absorption, afin d'isoler les ilots les uns des autres. Ensuite, pour ne pas perdre de matériau absorbant, et ainsi conserver un bon rendement quantique, il est préférable de former des tranchées **64** de largeur minimale. Ces deux contraintes sur la profondeur et la largeur nécessitent donc de réaliser des tranchées à fort facteur de forme, par exemple des tranchées d'une profondeur de 10 µm et d'une largeur de 2 µm. Or, graver ce type de tranchées, d'une part en respectant les contraintes géométrique, et d'autre part en évitant d'introduire des défauts de structures ou de compositions dans les matériaux des ilots, est très difficile. En outre, le dépôt de la couche de passivation **68** sur toute la surface d'une tranchée à facteur de forme élevée est également difficile.

Ainsi donc la géométrie de type "tête-bêche" est difficile à fabriquer et implique une absence de cohérence temporelle des détections.

Le document US6034407 divulgue un configuration connue de diodes planaires en parallèle.

### EXPOSE DE L'INVENTION

Le but de la présente invention est de proposer un détecteur bispectral de fabrication simplifiée, présentant une cohérence temporelle et spatiale élevée, ainsi qu'un taux de remplissage important.

A cet effet, l'invention a pour objet un détecteur bispectral selon la revendication 1, comprenant une pluralité d'éléments unitaires de détection d'une première et seconde gammes de rayonnements électromagnétiques, comportant :
▪ un empilement de couches semi-conductrices supérieure et inférieure d'un premier type de conductivité pour l'absorption des première et seconde gammes de rayonnements électromagnétiques respectivement, séparées par une couche intermédiaire formant barrière de potentiel entre les couches supérieure et inférieure ; et
▪ pour chaque élément unitaire de détection, deux zones semi-conductrices supérieure et inférieure d'un second type de conductivité opposé au premier type, sont agencées respectivement au contact des faces supérieures des couches supérieure et inférieure de manière à former des jonctions PN, la zone semi-conductrice au contact de la couche inférieure étant agencée dans le fond d'un évidement traversant les couches supérieure et intermédiaire.

Selon l'invention,
▪ la face supérieure de la couche supérieure est recouverte entièrement d'une couche semi-conductrice du second type de conductivité ;
▪ et des tranchées sont réalisées dans la face supérieure à travers ladite couche semi-conductrice jusqu'à ladite couche supérieure autour de chaque élément unitaire de détection.

En d'autres termes, le détecteur selon l'invention présente globalement la structure de d'un détecteur « en parallèle » de l'état de la technique avec la photodiode supérieure présentant une géométrie du type « mesa ».

Le simple fait de prévoir une telle géométrie « mesa » dans un détecteur « en parallèle » a pour effet :
▪ de conserver la cohérence temporelle, les deux photodiodes étant polarisables séparément ;
▪ de disposer d'un facteur de forme réduit, et donc une fabrication simplifiée par rapport à la géométrie "tête-bêche" de l'état de la technique, car il n'est pas nécessaire de graver les deux couches d'absorption puisque l'empilement des photodiodes est du type NPNP. Ainsi, la profondeur des tranchées est réduite ;
▪ d'avoir un taux de remplissage maximum en prévoyant :
   a. soit deux photodiodes de type mésa formées chacune de deux couches P et N superposées,
   b. soit une photodiode de type mésa formée de deux couches P et N superposées et l'autre photodiode réalisée par implantation et ayant une zone de collection optimisée par exemple par l'application d'un recuit approprié ; et
▪ d'avoir si l'application le nécessite, une cohérence spatiale exacte, les photodiodes pouvant parfaitement se superposer.

Notamment, le dopage de la couche supérieure ou inférieure dans laquelle sont réalisées les zones semi-conductrice de second type de conductivité, notamment par un procédé de type "planar", est choisi de manière à ce que la longueur de diffusion des porteurs de charge dans ladite couche soit maximale.

L'invention a également pour objet un procédé de fabrication d'un détecteur bispectral selon la revendication 3, comprenant une pluralité d'éléments unitaires de détection d'une première et seconde gammes de rayonnements électromagnétiques, comportant :
▪ la réalisation d'un empilement de couches semi-conductrices supérieure et inférieure d'un premier type de conductivité pour l'absorption des première et seconde gammes de rayonnements électromagnétiques respectivement, séparées par une couche intermédiaire formant barrière de potentiel entre les couches supérieure et inférieure ; et
▪ pour chaque élément unitaire de détection, la formation de deux zones semi-conductrices supérieure et inférieure d'un second type de conductivité opposé au premier type, agencées respectivement au contact des couches supérieure et inférieure de manière à former des jonctions PN, la zone semi-conductrice au contact de la couche inférieure étant agencée dans le fond d'un évidement traversant les couches supérieure et intermédiaire.

Selon l'invention :
▪ la face supérieure de la couche supérieure est entièrement recouverte d'une couche semi-conductrice du second type de conductivité ;
▪ et des tranchées sont réalisées dans la face supérieure à travers ladite couche semi-conductrice jusqu'à ladite couche supérieure autour de chaque élément unitaire de détection.

Selon un mode de réalisation de l'invention : un recuit est appliqué à l'empilement de manière à ce que la couche supérieure présente une longueur de diffusion des porteurs de charge dans ladite couche maximale.

Plus particulièrement, les zones semi-conductrices au contact de la couche inférieure sont réalisées en formant des motifs dans une résine photosensible, déposée sur la couche inférieure, qui délimitent les zones semi-conductrice, et en réalisant un dopage de la couche inférieure au travers des motifs de résine, notamment par implantation ionique, diffusion, ou usinage ionique.

### BREVE DESCRIPTION DES FIGURES

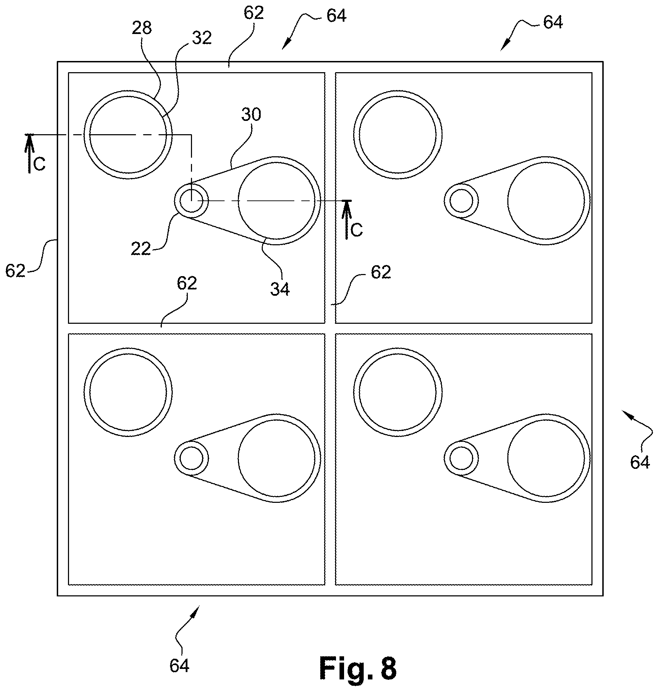

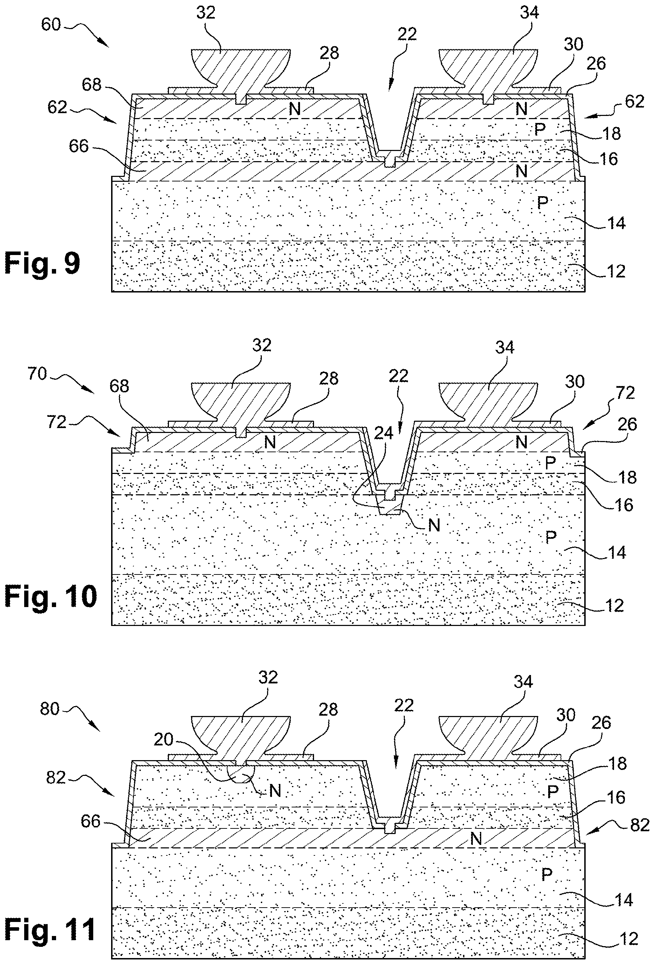

L'invention sera mieux comprise à la lecture de la description qui va suivre, donnée uniquement à titre d'exemple, et faite en relation avec les dessins annexés, dans lesquels des références identiques désignent des éléments identiques ou analogues, et dans lesquels :
▪ les figures 1 et 2 sont des vues de dessus et en coupe d'un détecteur matriciel de type « parallèle » de l'état de la technique, tel que déjà décrit dans le préambule ;
▪ la figure 3 est un profil de composition en cadmium des couches de l'empilement du détecteur des figures 1 et 2, tel que déjà décrit dans le préambule ;
▪ la figure 4 est une vue en coupe de détail de la figure 2 illustrant une zone de collection, telle que déjà décrit dans le préambule ;
▪ les figures 5 et 6 sont des vues de dessus et en coupe d'un détecteur matriciel de type "tête-bêche" de l'état de la technique, tel que déjà décrit dans le préambule ;
▪ la figure 7 est un profil de composition en cadmium des couches de l'empilement du détecteur des figures 5 et 6, tel que déjà décrit dans le préambule ;
▪ les figures 8 et 9 sont des vues de dessus et en coupe d'un détecteur matriciel selon un premier mode de réalisation qui ne fait pas partie de l'invention;
▪ la figure 10 est une vue en coupe d'un détecteur matriciel selon un deuxième mode de réalisation qui illustre l'invention ; et
▪ la figure 11 est une vue en coupe d'un détecteur matriciel selon un troisième mode de réalisation qui ne fait pas partie de l'invention.

### DESCRIPTION DETAILLEE DE L'INVENTION

Comme dit plus haut, l'invention consiste essentiellement à combiner une géométrie de pixel du type « parallèle » avec au moins une photodiode de géométrie du type « mesa ».

Selon l'invention, le détecteur matriciel de type « parallèle » de l'état de la technique décrit en relation avec les figures 1 à 3, est modifié tel que défini dans la revendication 1, en prévoyant des tranchées autour de chaque pixel du détecteur afin de définir au moins une photodiode de type « mesa ».

### PREMIER MODE DE RÉALISATION

Il va à présent être décrit un détecteur **60** selon un premier mode de réalisation en relation avec les figures 8 et 9. La figure 8 est une vue de dessus illustrant une matrice de deux pixels par deux pixels, et la figure 9 est une vue en coupe de la figure 8 selon l'axe C-C.

Le détecteur **60** diffère du détecteur **10** des figures 1 à 3 par la forme des zones semi-conductrices de type N implantées dans les couches **14** et **18** de l'empilement, et par la présence de tranchées **62** autour de chaque pixel **64**.

Plus particulièrement, les zones de type N **20** et **24** de l'état de la technique sont respectivement remplacées par des couches de type N **66** et **68** qui recouvrent entièrement les couches d'absorption de type P **14** et **18**.

Avantageusement, la couche N **66** et la couche P **14**, ainsi que la couche N **68** et la couche P **18**, sont réalisées lors d'une même étape de croissance par épitaxie en introduisant les dopants appropriés dans l'alliage CdₓHg₁₋ₓTe afin d'obtenir la composition en cadmium et le caractère N ou P souhaités.

Les pixels sont alors individualisés en gravant les tranchées **62** dans la face supérieure de l'ensemble jusqu'à la couche P **14**, et la surface des tranchées **62** est également recouverte par la couche de passivation **26**.

Le premier mode de réalisation présente ainsi des photodiodes supérieure et inférieure de type « mesa » sans pour autant en présenter l'inconvénient de nécessiter un facteur de forme important.

Les avantages de ce mode de réalisation sont ainsi nombreux :
▪ une fabrication simple de l'ensemble des couches **14**, **66**, **16**, **18**, **68**, par exemple par épitaxie avec modulation des dopants, suivie de la formation des tranchées **62**, par exemple par gravure, jusqu'à la couche P **14**. La couche P **14** ne nécessitant pas d'être gravée pour isoler les pixels les uns des autres, la profondeur des tranchées **62** est donc limitée ;
▪ une cohérence spatiale exacte puisqu'il y a superposition des photodiodes **14**, **66** et **18**, **68** ;
▪ une cohérence temporelle exacte puisqu'il existe deux reprises de contact distinctes par pixel ; et
▪ compte tenu de l'épaisseur donnée des couche d'absorption P **14** et **18**, un taux de remplissage optimal pour chacune des photodiodes puisque les couches N **66**, **68** recouvrent l'entière surface des couches d'absorption P **14** et **18**.

Par ailleurs, pour minimiser la profondeur des tranchées **62** et augmenter le taux de remplissage des pixels **64**, il est également possible de réduire l'épaisseur de la couche d'absorption **18**.

On notera que les évidements **22** ont un facteur de forme plus avantageux que les tranchées **62**. En effet, tout d'abord, leur profondeur est moindre, par construction, puisqu'ils ne vont que jusqu'à environ la moitié de l'empilement. Ensuite, leur largeur est aussi plus importante, puisqu'il faut définir au fond de l'évidement des motifs (comme la reprise de contact dans la zone **24** par exemple). Ceci nécessite des étapes de photolithographie et d'implantation ou de gravure, dont les dimensions sont de l'ordre de quelques micromètres. Donc leur largeur est aussi plus importante que celle des tranchées **62**, au fond desquelles on n'a pas besoin de définir de motifs technologiques.

### DEUXIEME MODE DE REALISATION

Dans le mode de réalisation venant d'être décrit, le facteur de forme des tranchées 62, bien que fortement réduit par rapport à l'état de la technique des détecteurs de type "tête-bêche", peut encore être considéré comme trop important.

Un deuxième mode de réalisation, conforme à l'invention et illustré par la vue en coupe de figure 10, diffère du premier mode de réalisation en ce que les zones semi-conductrices de type N 24 réalisées au contact de la couche d'absorption 14 pour former les jonctions PN inférieures sont réalisées au fond des évidements **22** par un procédé de type "planar", de manière analogue aux zones **24** de l'état de la technique par dopage extrinsèque de dopants N, par exemple par implantation ionique, ou par implantation ionique et conversion du dopage intrinsèque de type P en type N, ou par diffusion.

Les zones **24** ont par exemple un diamètre compris entre 2 et 10 micromètres.

Les photodiodes supérieures sont alors individualisées en gravant des tranchées **72** dans la face supérieure de l'ensemble jusqu'à la couche d'absorption supérieure **18**. La profondeur des tranchées **72** est donc faible et les tranchées **72** encore plus simplement réalisables. Les photodiodes supérieures présentent alors une géométrie de type « mesa » et les photodiodes inférieures présentent une géométrie de type « planar ».

Le taux de remplissage des photodiodes supérieures **68**, **18** est ici optimal par construction compte tenu de l'épaisseur souhaitée pour la couche d'absorption **18**.

Par ailleurs, le taux de remplissage des photodiodes inférieures **24**, est quant à lui avantageusement maximisé en augmentant la longueur de diffusion *L_{d}* dans la couche **14** par application d'un recuit approprié, tel que celui décrit par exemple dans le document « Electrical doping of HgCdTe by ion implantation and heat treatment » de G.L. Destefanis, J. Crystal Growth, 86, 1988, 700-722.

Par rapport au premier mode de réalisation, les cohérences spatiale et temporelle sont conservées. Par ailleurs, le taux de remplissage optimal des photodiodes inférieures est lui aussi conservé, puisqu'on a dans la structure une seule diode de type « planar », et qu'il est donc possible de régler de façon optimale la longueur de diffusion dans la couche **14**, et ainsi maximiser le remplissage des photodiodes **24**.

Par ailleurs, cette solution présente l'avantage spécifique que les tranchées **72** à creuser pour séparer les ilots qui forment les diodes supérieures sont particulièrement peu profondes, puisqu'elles ne traversent que la couche N supérieure **68**. Le procédé de fabrication est donc simplifié, et des rendements de fabrication élevés sont plus facilement obtenus.

Dans l'exemple décrit, la couche d'absorption est de type P. Bien entendu, il est possible d'inverser les dopages en prévoyant des couches d'absorption de type N. Dans ce cas, la longueur de diffusion dans un matériau semi-conducteur de type N étant usuellement très supérieure à la longueur de diffusion dans un matériau semi-conducteur de type P, les tranchées **72** peuvent avantageusement être réalisées au travers de la couche formant barrière **16** jusqu'à la couche d'absorption inférieure **14** afin de réduire de possibles phénomènes de cross-talk.

### TROISIEME MODE DE REALISATION

Dans le troisième mode de réalisation, illustré par la vue en coupe de figure 11, la structure du détecteur **80** est inversée par rapport au détecteur **70** du deuxième mode de réalisation.

Plus particulièrement, les photodiodes supérieures sont du type « planar », avec des zones semi-conductrices N **20** implantées dans la couche d'absorption **18** de manière analogue à celles de l'état de la technique. Les photodiodes inférieures sont du type « mesa » en étant formées par une couche N **66** recouvrant la couche d'absorption P **14**, des tranchées **82** étant formées dans la face supérieure de l'ensemble jusqu'à la couche **14** pour individualiser les pixels.

Le taux de remplissage des photodiodes inférieures **66**, **14** est ici optimal par construction compte tenu de l'épaisseur souhaitée pour la couche d'absorption **14**, et le taux de remplissage des photodiodes supérieures **20**, **18** est quant à lui avantageusement maximisé en augmentant la longueur de diffusion *L_{d}* dans la couche **18** par application d'un recuit approprié, tel que celui décrit par exemple dans le document « Electrical doping of HgCdTe by ion implantation and heat treatment » de G.L. Destefanis, J. Crystal Growth, 86, 1988, 700-722.

Tout comme pour le deuxième mode de réalisation, les cohérences spatiale et temporelle sont également conservées par rapport au premier mode de réalisation. Par ailleurs, le taux de remplissage optimal des photodiodes inférieures est lui aussi conservé, puisqu'on a dans la structure une seule diode de type « planar », et qu'il est donc possible de vraiment régler de façon optimale la longueur de diffusion dans la couche **18**, et maximiser le remplissage des photodiode **20**.

Par ailleurs, cette solution présente l'avantage spécifique que le bord de la jonction P/N supérieure ne touche pas le flanc de l'évidement **22**. Or la zone proche du flanc de l'évidement est, à cause des étapes de gravure et de passivation qui permettent de la construire, une zone plus susceptible que le reste de la structure de contenir des défauts dans le matériau, qui pourraient conduire à des défauts électro-optiques dans le fonctionnement des photodiodes. Eloigner le bord de la jonction P/N de cette zone conduit donc à de meilleures performances des matrices de photodiodes ainsi construites.

A titre d'exemple, dans les trois modes de réalisation venant d'être décrits :
▪ le pas des pixels est compris entre 15 et 30 micromètres ;
▪ les évidements **22** sont par exemple cylindriques et ont un diamètre compris entre 4 et 12 micromètres ;
▪ les tranchées d'individualisation des pixels ont une largeur comprise entre 2 et 5 micromètres ;
▪ la couche inférieure **14** a une épaisseur de 5 micromètres et une composition en cadmium *x₁₄* de 0,3. La couche **14** est ainsi réglée sur la longueur d'onde 5,1 micromètres pour une température de 77K, et présente un gap E_{g} = 0, 24 eV, permettant ainsi une détection dans les infrarouges moyens ;
▪ la couche supérieure **18** a une épaisseur de 3 micromètres et une composition en cadmium *x₁₈* de 0,22. La couche **18** est ainsi réglée sur la longueur d'onde 10.7 micromètres pour une température de 77K et présente un gap Eg = 0,11 eV, permettant ainsi une détection dans les infrarouges lointains ; et
▪ la couche intermédiaire **16** a une épaisseur de 1 micromètre et une composition en cadmium *x₁₆* de 0,8. La couche **16** présente ainsi un gap Eg = 1,1 eV.

Les valeurs numériques données ci-dessus permettent une détection à la fois dans les infrarouges moyens et lointains. Bien entendu d'autres détections sont possibles en sélectionnant des matériaux appropriés, notamment dans les infrarouges courts (entre 1 et 2,5 micromètres à 77°K), moyens (entre 2,5 et 5,5 micromètres à 77°K), lointains (entre 8 et 12 micromètres à 77°K) et très lointains (au-delà de 12 micromètres à 77°K).

De même il a été décrit des modes de réalisation dans lesquels les couches d'absorption sont de type P. L'invention s'applique également aux couches d'absorption de type N.

De même, il a été décrit une application de l'invention dans le cadre de la mise en œuvre d'alliages CdₓHg₁₋ₓTe qui sont des matériaux pour lesquels il est particulièrement difficile de graver des tranchées avec un important facteur de forme. Bien entendu, l'invention s'applique également à d'autres types de matériaux semi-conducteurs.

## Revendications

1. Détecteur bispectral comprenant une pluralité d'éléments unitaires de détection (64) d'une première et seconde gammes de rayonnements électromagnétiques, comportant :
▪ un empilement de couches semi-conductrices supérieure (18) et inférieure (14) d'un premier type de conductivité pour l'absorption des première et seconde gammes de rayonnements électromagnétiques respectivement, séparées par une couche intermédiaire (16) formant barrière de potentiel entre les couches supérieure (18) et inférieure (14) ; et
▪ pour chaque élément unitaire de détection, deux zones semi-conductrices supérieure (68) et inférieure (24) d'un second type de conductivité opposé au premier type de condutivité, sont agencées respectivement au contact des faces supérieures des couches supérieure (18) et inférieure (14) de manière à former des jonctions PN, la zone semi-conductrice (24) au contact de la couche inférieure (14) étant agencée dans le fond d'un évidement (22) traversant les couches supérieure (18) et intermédiaire (16),
***caractérisé*** :
▪ en ce que la face supérieure de la couche supérieure (18) est recouverte entièrement d'une couche semi-conductrice (68) du second type de conductivité ;
▪ et en ce que des tranchées (72) sont réalisées dans la face supérieure à travers ladite couche semi-conductrice (68) jusqu'à ladite couche supérieure (18) autour de chaque élément unitaire de détection (64) .

2. Détecteur bispectral selon la revendication 1, ***caractérisé* en ce que** le dopage de la couche supérieure (18) ou inférieure (14) dans laquelle sont implantées les zones semi-conductrices (24) est choisi de manière à ce que la longueur de diffusion des porteurs de charge dans ladite couche soit maximale.

3. Procédé pour la fabrication d'un détecteur bispectral comprenant une pluralité d'éléments unitaires de détection (64) d'une première et seconde gammes de rayonnements électromagnétiques, comportant :
▪ la réalisation d'un empilement de couches semi-conductrices supérieure (18) et inférieure (14) d'un premier type de conductivité pour l'absorption des première et seconde gammes de rayonnements électromagnétiques respectivement, séparées par une couche intermédiaire (16) formant barrière de potentiel entre les couches supérieure (18) et inférieure (14) ; et
▪ pour chaque élément unitaire de détection, la formation de deux zones semi-conductrices supérieure (68) et inférieure (24) d'un second type de conductivité opposé au premier type de conductivité, agencées respectivement au contact des couches supérieure (18) et inférieure (14) de manière à former des jonctions PN, la zone semi-conductrice (24) au contact de la couche inférieure (14) étant agencée dans le fond d'un évidement (22) traversant les couches supérieure (18) et intermédiaire (16),
***caractérisé*** :
▪ en ce que la face supérieure de la couche supérieure (18) est entièrement recouverte d'une couche semi-conductrice (68) du second type de conductivité ;
▪ et en ce que des tranchées (72) sont réalisées dans la face supérieure à travers ladite couche semi-conductrice (68) jusqu'à ladite couche supérieure (18) autour de chaque élément unitaire de détection (64).

4. Procédé pour la fabrication d'un détecteur bispectral selon la revendication 3, ***caractérisé*** :
▪ en ce qu'un recuit est appliqué à l'empilement de manière à ce que la couche supérieure présente une longueur de diffusion des porteurs de charge dans ladite couche maximale.

5. Procédé pour la fabrication d'un détecteur bispectral selon la revendication 3 ou 4, ***caractérisé* en ce que** les zones semi-conductrices (24) au contact de la couche inférieure (14) sont réalisées en formant des motifs dans une résine photosensible, déposée sur la couche inférieure (14), qui délimitent les zones semi-conductrice (24), et en réalisant un dopage de la couche inférieure (14) au travers des motifs de résine, notamment par implantation ionique, diffusion, ou usinage ionique.

## Patentansprüche

1. Bispektraler Mehrschichtdetektor mit mehreren einzelnen Messfühlern (64) eines ersten und eines zweiten elektromagnetischen Wellenspektrums, umfassend:
▪ einen Stapel, der eine obere (18) und eine untere (14) Halbleiterschicht mit einem ersten Leitfähigkeitstyp enthält, zur Absorption des ersten bzw. zweiten Spektrums elektromagnetischer Strahlung, unterteilt durch eine Zwischenschicht (16), die eine Potentialbarriere zwischen der oberen Schicht (18) und der unteren Schicht (14) bildet; und
▪ für jeden einzelnen Messfühler zwei Halbleiterschichten, eine obere (68) und eine untere (24) Halbleiterschicht eines zweiten Leitfähigkeitstyps, entgegengesetzt zum ersten Leitfähigkeitstyp, die jeweils in Kontakt mit den Oberseiten der oberen (18) und unteren (14) Schicht angeordnet sind, so dass sie PN-Verbindungen bilden, wobei die Halbleiterschicht (24), die Kontakt mit der unteren Schicht (14) hat, auf dem Boden einer Aussparung (22) angeordnet ist, die durch die obere (18) und die Zwischenschicht (16) hindurchführt.
***gekennzeichnet dadurch, dass:***
▪ die Oberseite der oberen Schicht (18) vollständig von einer Halbleiterschicht (68) des zweiten Leitfähigkeitstyps bedeckt ist;
▪ und dadurch, dass Einschnitte (72) in der Oberseite durch diese Halbleiterschicht (68) hindurch, bis zur genannten oberen Schicht (18), um jeden einzelnen Messfühler (64) herum, ausgeführt werden.

2. Bispektraler Mehrschichtdetektor nach Anspruch 1, ***gekennzeichnet dadurch, dass*** die Dotierung der oberen (18) oder unteren (14) Schicht, in der die Halbleiterschichten (24) angeordnet sind, so ausgewählt wird, dass die Diffusionslänge der Ladungsträger in dieser Schicht maximal ist.

3. Verfahren zur Herstellung eines bispektralen Mehrschichtdetektors mit mehreren einzelnen Messfühlern (64) eines ersten und eines zweiten elektromagnetischen Wellenspektrums, umfassend:
▪ die Herstellung eines Stapels, der eine obere (18) und eine untere Halbleiterschicht (14) mit einem ersten Leitfähigkeitstyp enthält, zur Absorption des ersten bzw. zweiten Bereichs elektromagnetischer Strahlung, unterteilt durch eine Zwischenschicht (16), die eine Potentialbarriere zwischen der oberen Schicht (18) und der unteren Schicht (14) bildet; und
▪ für jeden einzelnen Messfühler die Bildung von zwei Halbleiterschichten, eine obere (68) und eine untere (24) Halbleiterschicht, eines zweiten Leitfähigkeitstyps, entgegengesetzt zum ersten Leitfähigkeitstyp, die jeweils in Kontakt mit der oberen (18) und unteren (14) Schicht angeordnet sind, so dass sie PN-Verbindungen bilden, wobei die Halbleiterschicht (24), die Kontakt mit der unteren Schicht (14) hat, auf dem Boden einer Aussparung (22) angeordnet ist, die durch die obere (18) und die Zwischenschicht (16) hindurchführt,
***gekennzeichnet dadurch, dass**:*
▪ die Oberseite der oberen Schicht (18) vollständig von einer Halbleiterschicht (68) des zweiten Leitfähigkeitstyps bedeckt ist;
▪ und dadurch, dass Einschnitte (72) in der Oberseite durch diese Halbleiterschicht (68) hindurch bis zur genannten oberen Schicht (18), um jeden einzelnen Messfühler (64) herum, ausgeführt werden.

4. Verfahren zur Herstellung eines bispektralen Detektors gemäß Anspruch 3 **gekennzeichnet dadurch, dass**:
▪ ein Temperung auf dem Stapel aufgebracht wird, so dass die obere Schicht eine maximale Diffusionslänge der Ladungsträger in dieser Schicht aufweist.

5. Verfahren zur Herstellung eines bispektralen Detektors gemäß Anspruch 3 oder *4, **gekennzeichnet dadurch, dass*** die die Halbleiterschichten (24), die Kontakt mit der unteren Schicht (14) haben, so ausgeführt werden, dass sie Muster in einem fotosensiblen Harz bilden, das auf der unteren Schicht (14) aufgebracht ist, die die Halbleiterschichten (24) begrenzen und dass sie eine Dotierung der unteren Schicht (14) durch die Harzmuster hindurch, insbesondere durch Ionenimplantation, Diffusion oder Ionenbearbeitung ausführen.

## Claims

1. A bispectral detector comprising a plurality of unitary elements (64) for detecting a first and a second electromagnetic radiation range, consisting of:
▪ a stack of upper (18) and lower (14) semiconductor layers of a first conductivity type in order to absorb a first and a second electromagnetic radiation range respectively and which are separated by an intermediate layer (16) that forms a potential barrier between the upper (18) and lower (14) layers; and
▪ for each unitary detection element, two upper (68) and lower (24) semiconductor zones of a second conductivity type opposite to the first conductivity type, are arranged respectively so that they are in contact with the upper faces of the upper (18) and lower (14) layers so as to form PN junctions, the semiconductor zone (24) that is in contact with the lower layer (14) being positioned in the bottom of an opening (22) that passes through the upper (18) and intermediate (16) layers,
***characterized:***
▪ in that the upper face of the upper layer (18) is entirely covered in a semiconductor layer (68) of the second conductivity type;
▪ and in that cuts (72) are made around each unitary detection element (64) from the upper face through the thickness of said semiconductor layer (68) until said upper layer (18).

2. The bispectral detector as claimed in claim 1, ***characterized* in that** the doping of upper layer (18) or lower layer (14) in which semiconductor zones (24) are implanted is chosen so that the charge carrier diffusion length in said layer is maximized.

3. A method for manufacturing a bispectral detector comprising a plurality of unitary elements (64) for detecting a first and a second electromagnetic radiation range, involving:
▪ producing a stack of upper (18) and lower (14) semiconductor layers of a first conductivity type in order to absorb a first and a second electromagnetic radiation range respectively and which are separated by an intermediate layer (16) that forms a potential barrier between the upper (18) and lower (14) layers; and
▪ for each unitary detection element, forming two upper (68) and lower (24) semiconductor zones of a second conductivity type opposite to the first conductivity type, arranged respectively so that they are in contact with the upper (18) and lower (14) layers so as to form PN junctions, the semiconductor zone (24) that is in contact with the lower layer (14) being positioned in the bottom of an opening (22) that passes through the upper (18) and intermediate (16) layers,
***characterized:***
▪ in that the upper face of the upper layer (18) is entirely covered in a semiconductor layer (68) of the second conductivity type;
▪ and in that cuts (72) are made around each unitary detection element (64) from the upper face through the thickness of said semiconductor layer (68) until said upper layer (18).

4. The method for manufacturing a bispectral detector as claimed in claim 3, ***characterized* in that** a heat treatment is applied to the stack so that the upper layer has a charge carrier diffusion length that is maximized.

5. The method for manufacturing a bispectral detector as claimed in claim 3 or 4, ***characterized* in that** the semiconductor zones (24) that are in contact with the lower layer (14) are produced by forming patterns in a photoresist that is deposited on the lower layer (14) which delimit semiconductor zones (24) and by doping the lower layer (14) layers through the photoresist patterns, especially by ion implantation, diffusion or ion beam milling.
